# EUROPÄISCHE PATENTANMELDUNG

(11) **EP 2 043 171 A2**
(43) Veröffentlichungstag der Anmeldung: **01.04.2009**
(21) Anmeldenummer: 08105328.2
(22) Anmeldetag: 12.09.2008
(51) Int. Cl.: H01L 41/047, H01L 41/083, H01L 41/22

(54) **Piezoaktormodul mit mehreren untereinander verbundenen Piezoaktoren und ein Verfahren zu dessen Herstellung**

(30) Priorität: 27.09.2007 DE 102007046314
(71) Anmelder: Robert Bosch GmbH, 70442 Stuttgart (DE)
(72) Erfinder: Cromme, Peter, 96050 Bamberg (DE); Herr, Michael, 96052 Bamberg (DE)

(57) **Zusammenfassung**

Es wird ein Piezoaktormodul (1) mit mindestens zwei in der mechanischen Wirkungsrichtung hintereinander geschalteten Piezoaktoren (2,3) vorgeschlagen, die jeweils aus in der mechanischen Wirkungsrichtung hintereinander geschalteten Piezoelementen mit über Außenelektroden (7,8) kontaktierten Innenelektroden (4,5) wechselnder Polarität bestehen. Es ist jeweils eine gemeinsame Außenelektrode (7,8) für den Pluspol der mindestens zwei Piezoaktoren (2,3) und eine gemeinsame Außenelektrode (7) für den Minuspol der mindestens zwei Piezoaktoren (2,3) vorhanden.

## Beschreibung

### Stand der Technik

Die Erfindung betrifft ein von flüssigen Medien umströmtes Piezoaktormodul mit einer Anordnung von mehreren mechanisch in Reihe geschalteten Piezoaktoren, vorzugsweise zur Verwendung in einem Piezoinjektor, nach den gattungsgemäßen Merkmalen des Anspruchs 1 und des Verfahrensanspruchs 6.

Ein solcher Piezoinjektor besteht im wesentlichen aus einem Haltekörper und dem in dem Haltekörper angeordneten Piezoaktormodul, das die zwischen einem Kopf- und Fußteil und Anbindebauteilen angeordneten Piezoaktoren aufweist, die jeweils aus mehreren übereinandergestapelten Piezoelementen aufgebaut sind.

Es ist an sich bekannt, dass zum Aufbau des zuvor erwähnten Piezoaktors Piezoelemente so eingesetzt werden können, dass unter Ausnutzung des sogenannten Piezoeffekts eine Steuerung des Nadelhubes eines Ventils oder dergleichen vorgenommen werden kann. Piezolagen der Piezoelemente sind aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen. In der Regel bestehen die Piezoaktoren aus ca. 2 bis 3 mm hohen Paketen aus mehreren Piezolage und Innenelektroden.

Beispielsweise ist ein solcher Piezoaktor als Bestandteil eines Piezoinjektors in sogenannten Common Rail Einspritzsystemen (CR-Injektor) aus der DE 10026005 A1 bekannt. Bei diesem Piezoaktor sind ebenfalls Piezoelemente als Stapel angeordnet, der über einen Aktorfuß und einen Aktorkopf unter Vorspannung zwischen zwei Anschlägen gehalten ist. Jede Piezolage ist auch hier zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei diesen bekannten CR-Injektoren ist in der Regel eine indirekt vom Piezoaktormodul gesteuerte Düsennadel als Kraftstoffventil vorhanden, wobei die Piezoaktoren eine Realisierung der Öffnungs-und Schließfunktion ermöglicht. Für eine Anwendung dieser Piezoinjektoren mit direkter Nadelsteuerung in einem Kraftstoffdruck bis zu 2000 bar reicht jedoch der Hub eines einzelnen Piezoaktors nicht zu der direkten Steuerung aus. Der notwendige Mindesthub kann nun dadurch realisiert werden, dass mindestens zwei Piezoaktoren stirnseitig zu einer Aktorreihe aneinandergefügt werden.

Es ist dabei hinlänglich bekannt, dass diese Reihe aus mehreren einzelnen Piezoaktoren beispielsweise zusammengeklebt ist und gekapselt in einer metallischen Hülse das Herzstück des zuvor erläuterten Piezoinjektors bildet. Die elektrische Verbindung der einzelnen Piezoaktoren kann dabei in an sich bekannter Weise beispielsweise durch Spaltschweißen einer elektrisch leitenden Brücke zwischen den Außenelektroden der einzelnen Piezoaktoren realisiert werden. Ein Schutz dieser Reihe von Piezoaktoren gegen den Kraftstoff kann beispielsweise durch eine aus der DE 102 17 361 A1 bekannte dieselresistente Beschichtung, die üblicherweise aus mehreren Schichten mit unterschiedlicher Funktionen besteht, erreicht werden.

Durch das zuvor erwähnte Spaltschweißen und die Brücke, zum Beispiel eine Siebbrücke, ergeben sich Nachteile wahrend des Aufbaus des Piezoaktormoduls sowie für nachfolgende Beschichtungsprozesse. Solche Brücken stellen eine geometrische Inhomogenität auf der Außenfläche der Reihe der Piezoaktoren dar, die zu erheblichen Problemen wahrend der Beschichtung mit einer dieselresistenten Beschichtung, bestehend aus einer oder mehren Schichten, führt. Der Schweißvorgang muss dabei teilweise in dem Bereich der aktiven Piezolagen auf den Außenelektroden der Piezoaktoren durchgeführt werden, wobei der Wärmeeintrag durch den Schweißprozess ein hohes Schädigungsrisiko birgt. Eventuell entstehende Schmauchspuren im Bereich der Schweißstellen stellen ein Risiko für die nachfolgende Beschichtungsschritte dar, wobei es hierbei schwierig ist, keine Blasen unter dem Bereich der Schweißstelle Außenelektrode-Brücke einzuschließen und dann ein aufwendiges manuelles Verfüllen notwendig ist. Weiterhin kann durch die beschriebene Inhomogenität bei einem Einsatz als Piezoinjektor für die Kraftstoffeinspritzung auch der Kraftstofffluss am Piezoaktormodul vorbei behindert werden.

### Offenbarung der Erfindung

Die Erfindung geht von einem Piezoaktormodul mit mindestens zwei in der mechanischen Wirkungsrichtung hintereinander geschalteten Piezoaktoren aus, die für sich gesehen jeweils aus in der mechanischen Wirkungsrichtung hintereinander geschalteten Piezoelementen mit über Außenelektroden kontaktierten Innenelektroden wechselnder Polarität bestehen. Erfindungsgemäß ist in vorteilhafter Weise eine gemeinsame Außenelektrode für den Pluspol der mindestens zwei Piezoaktoren und eine gemeinsame Außenelektrode für den Minuspol der mindestens zwei Piezoaktoren vorhanden. Mit der Erfindung sind somit die eingangs beschriebenen negativen Effekte des Verbindungsprozesses zwischen den einzelnen Außenelektroden, wie zum Beispiel durch einen Spaltschweißprozess, vermieden.

Es kann hierbei für eine erforderliche Stabilität der Reihe der Piezoaktoren vorteilhaft sein, wenn die mindestens zwei Piezoaktoren stoffschlüssig, beispielsweise durch Kleben, unterhalb der auf die Piezoaktoren übergreifend aufgebrachten Außenelektroden aneinandergefügt sind.

Es kann andererseits aber auch vorteilhaft sein, wenn die mindestens zwei Piezoaktoren kraftschlüssig unterhalb der auf die Piezoaktoren übergreifend aufgebrachten Außenelektroden aneinandergefügt sind, so dass die Reihe der Piezoaktoren untereinander eine gewisse mechanische Flexibilität durch die Gelenkfunktion an der Verbindungsstelle aufweist. So besteht die Möglichkeit, dass fertigungsbedingte Toleranzen in gewissen Grenzen durch ein Gleiten an den Piezoaktorstirnflächen im Bereich der jeweiligen Verbindungsstelle ausgeglichen werden können. Durch das Entfallen der Klebestelle zwischen den Stirnflächen der Piezoaktoren können aber auch Nachteile durch eine Alterung oder ein Setzen des Klebstoffes an der Klebestelle vermieden werden.

Mit der Erfindung ist in vorteilhafter Weise erreicht, dass eine Piezoaktorreihe aus Einzelpiezoaktoren mit dann 300 oder mehr Piezolagen aufgebaut werden kann.

Vorzugsweise sind die Außenelektroden jeweils einteilig hergestellte metallische Siebelektroden die mit einem entsprechenden Verbindungsprozess auf die Piezoaktoren zur Kontaktierung der jeweiligen Innenelektroden aufgelötet, zum Beispiel dampfphasengelötet, sind.

Bei einem vorteilhaften Verfahren zur Herstellung eines zuvor beschriebenen Piezoaktormoduls werden in einem ersten Verfahrensschritt die einzelnen Piezoaktoren kraft- oder stoffschlüssig aneinandergefügt und in einem zweiten Verfahrensschritt werden die Außenelektroden zur Kontaktierung der jeweiligen Innenelektroden auf die entsprechenden Seitenflächen der Piezoaktoren aufgelötet.

### Kurze Beschreibung der Zeichnungen

Ausführungsbeispiele des erfindungsgemäßen Piezoaktormoduls werden anhand der Zeichnung erläutert. Es zeigen:
Figur 1 einen Schnitt durch zwei aneinander gereihte Piezoaktoren für ein Piezoaktormodul, die in bekannter Weise mittels einer Brücke miteinander verbunden sind,
Figur 2 einen Schnitt durch zwei aneinander gereihte Piezoaktoren für ein Piezoaktormodul, die geklebt sind und gemeinsame Außenelektroden aufweisen und
Figur 3 einen Schnitt durch zwei kraftschlüssig aneinander gereihte Piezoaktoren, die gemeinsame Außenelektroden aufweisen.

### Ausführungsformen der Erfindung

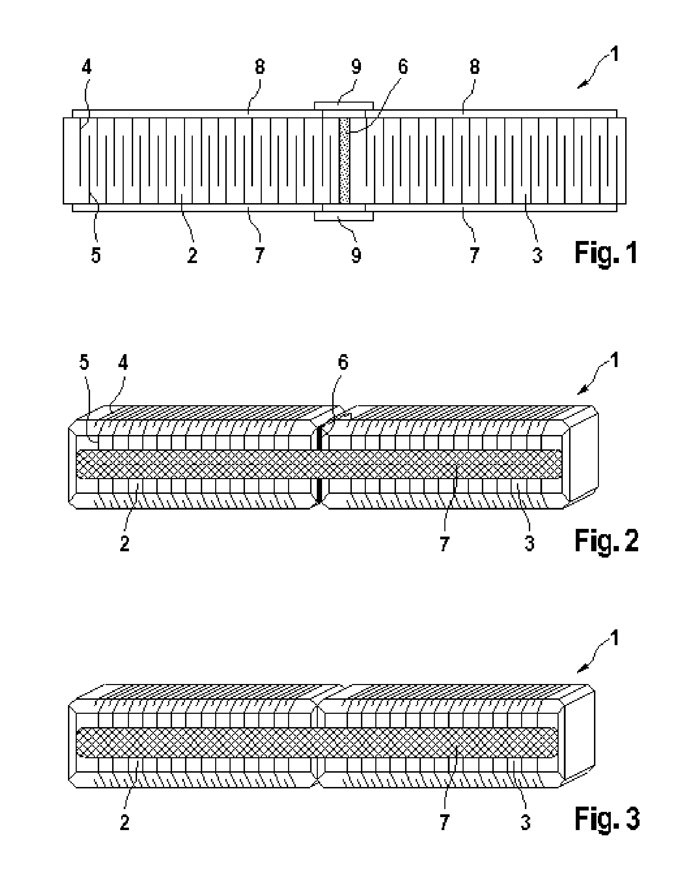

Im Folgenden wird ein Piezoaktormodul 1 erläutert, das beispielsweise für einen Piezoinjektor zur Nadelhubsteuerung in einem Einspritzsystem für Kraftstoff bei einem Verbrennungsmotor eingesetzt werden kann, wie es eingangs anhand des Standes der Technik beschrieben ist. Figur 1 zeigt zur Erläuterung der Nachteile des Standes der Technik eine herkömmliche Verbindung von zwei Piezoaktoren 2 und 3 im Piezoaktormodul 1.

Hierzu sind der Piezoaktor 2 und der Piezoaktor 3 in der mechanischen Wirkrichtung hintereinander geschaltet, so dass mit den in der Beschreibungseinleitung beschriebenen Piezoelementen ein mechanischer Hub in der Längserstreckung des Piezoaktormoduls 1 bewirkt werden kann. Die Piezoelemente werden durch Innenelektroden 4 der einen Polarität und Innenelektroden 5 der jeweils anderen Polarität und den dazwischenliegenden Piezolagen gebildet, wobei hier der Übersichtlichkeit wegen nur ein solches Piezoelement am linken Ende des Piezoaktors 2 mit den entsprechenden Bezugszeichen versehen worden ist. Beide Piezoaktoren 2 und 3 sind an den Stirnseiten mittels einer Klebestelle 6 stoffschlüssig miteinander verbunden.

Die Piezoaktoren 2 und 3 des Piezoaktormoduls 1 weisen jeweils Außenelektroden 7 und 8, Beispielswiese Siebelektroden, auf. Die Außenelektrode 7 kontaktiert hier jeweils die Innenelektroden 5 und die Außenelektrode 8 kontaktiert hier jeweils die Innenelektroden 4. Die Außenelektroden 7 und 8 können dabei mittels einer Dampfphasenlötung schon vor dem Zusammenfügen der Piezoaktoren 2 und 3 elektrisch leitend aufgebracht werden. Zur Verbindung der Außenelektroden 7 oder 8 der jeweils gleichen Polarität sind Brücken 9, zum Beispiel Siebbrücken, vorhanden, die beispielsweise durch Spalt- oder Laserschweißen mit den jeweiligen Außenelektroden 7 oder 8 kontaktiert sind. Diese bekannten Brücken 9 nach der Figur 1 bestehen in der Regel aus gefalteten Sieben und ragen daher einen gewissen Bereich aus der geometrischen Kontur der Piezoaktoren 2 und 3 heraus und bilden daher die in der Beschreibungseinleitung als nachteilig herausgestellten Inhomogenitäten.

Gemäß der Erfindung weist das Piezoaktormodul 1 nach Figur 2 jeweils eine durchgehende Außenelektrode 7 und eine hier nicht sichtbare Außenelektrode für die jeweils andere Polarität auf der gegenüberliegenden Seite der Piezoaktoren 2 und 3 auf, die hier als Siebelektrode ausgeführt ist. Die sichtbare Außenelektrode 7 kontaktiert hier die Innenelektroden 5, die nicht sichtbare Außenelektrode kontaktiert hier die Innenelektroden 4. Die Außenelektrode 7 und die gegenüberliegende Außenelektrode sind mittels einer Dampfphasenlötung nach dem Zusammenfügen der Piezoaktoren 2 und 3 elektrisch leitend aufgebracht. Die beiden Piezoaktoren sind auch hier über eine Klebestelle 6 miteinander verbunden.

Figur 3 zeigt ein Ausführungsbeispiel des erfindungsgemäßen Piezoaktormoduls 1, bei dem die in der Figur 2 vorhanden Klebstelle 6 weggefallen ist und die beiden Piezoaktoren 2 und 3 kraftschlüssig aneinanderliegen. Die Piezoaktoren 2 und 3 werden somit mechanisch über die gemeinsame Außenelektrode 7 und die gegenüberliegende Außenelektrode zusammengehalten und weisen an den aneinanderliegenden Stirnflächen in gewissen Grenzen eine Gelenkfunktion auf.

## Patentansprüche

1. Piezoaktormodul mit mindestens zwei in der mechanischen Wirkungsrichtung hintereinander geschalteten Piezoaktoren (2,3), die jeweils aus in der mechanischen Wirkungsrichtung hintereinander geschalteten Piezoelementen mit über Außenelektroden (7,8) kontaktierten Innenelektroden (4,5) wechselnder Polarität bestehen, **dadurch gekennzeichnet, dass** jeweils eine gemeinsame Außenelektrode (7,8) für den Pluspol der mindestens zwei Piezoaktoren (2,3) und eine gemeinsame Außenelektrode (7,8) für den Minuspol der mindestens zwei Piezoaktoren (2,3) vorhanden ist.

2. Piezoaktormodul nach Anspruch 1, **dadurch gekennzeichnet, dass** die mindestens zwei Piezoaktoren (2,3) kraftschlüssig unterhalb der auf die Piezoaktoren (2,3) übergreifend aufgebrachten Außenelektroden (7,8) aneinandergefügt sind.

3. Piezoaktormodul nach Anspruch 1, **dadurch gekennzeichnet, dass** die mindestens zwei Piezoaktoren (2,3) stoffschlüssig unterhalb der auf die Piezoaktoren (2,3) übergreifend aufgebrachten Außenelektroden (7,8) aneinandergefügt sind.

4. Piezoaktormodul nach Anspruch 3, **dadurch gekennzeichnet, dass** die stoffschlüssige Verbindung eine Klebeverbindung (6) ist.

5. Piezoaktormodul nach einem der vorhergehenden Ansprüche, **dadurch gekennzeichnet, dass** die Außenelektroden (7,8) jeweils einteilig hergestellte metallische Siebelektroden sind.

6. Verfahren zur Herstellung eines Piezoaktormoduls nach einem der vorhergehenden Ansprüche, **dadurch gekennzeichnet, dass** in einem ersten Verfahrensschritt die einzelnen Piezoaktoren (2,3) kraft- oder stoffschlüssig aneinandergefügt werden und in einem zweiten Verfahrensschritt die Außenelektroden (7,8) zur Kontaktierung der jeweiligen Innenelektroden (4,5) auf die entsprechenden Seitenflächen der Piezoaktoren (2,3) aufgelötet werden.
